# EUROPEAN PATENT APPLICATION

(11) **EP 2 919 564 A1**
(43) Date of publication of application: **16.09.2015**
(21) Application number: 14185185.7
(22) Date of filing: 17.09.2014
(51) Int. Cl.: H05K 1/03, H05K 3/12

(54) **Light emitting module substrate, light emitting module, and lighting device**

(30) Priority: 14.03.2014 JP 2014051477
(71) Applicant: Toshiba Lighting & Technology Corporation, Yokosuka-shi Kanagawa 237-8510 (JP)
(72) Inventor: Hino, Kiyokazu, Kanagawa, 237-8510 (JP)
(74) Representative: Bokinge, Ole

(57) **Abstract**

According to one embodiment, a light emitting module substrate includes: a base body that uses a ceramic; and a wiring pattern which is provided on a surface of the base body and in which a thickness in a region to be soldered is thicker than that in a region other than the region to be soldered.

## Description

### FIELD

Embodiments described herein relate generally to a light emitting module substrate, a light emitting module, and a lighting device.

### BACKGROUND

There is a lighting device including a base body, a light emitting module substrate having a wiring pattern provided on a surface of the base body, and a plurality of light emitting diodes (LED) provided on a wiring pattern.

Here, when the base body is formed by using a material having a high thermal conductivity, since an increase in a temperature of the light emitting diodes can be suppressed, it is possible to increase an amount of light. Thus, a base body formed using a ceramic is proposed.

The wiring pattern is formed by a screen printing method and the like on a surface of the base body formed using the ceramic.

However, if the wiring pattern is formed by using the screen printing method and the like, a pinhole reaching an interface between the wiring pattern and the base body may be formed in the wiring pattern.

If the pinhole reaching the interface between the wiring pattern and the base body is formed on the wiring pattern, there is a concern that a fixing strength between the wiring pattern and the base body may decrease and reliability may decrease.

In addition, in order to improve solder wettability or to suppress migration, if a metal layer covering the wiring pattern is formed by using an electroless plating method, acidic chemical solution may enter the inside of the pinhole. If the acidic chemical solution enters the inside of the pinhole, there is a concern that the pinhole may become larger, the fixing strength between the wiring pattern and the base body may decrease, and the reliability may decrease further.

Development of a light emitting module substrate, a light emitting module, and a lighting device which can improve reliability is desired.

### DESCRIPTION OF THE DRAWINGS

FIG. 1 is a schematic perspective view of a lighting device according to an embodiment.
FIG. 2 is a schematic perspective exploded view of the lighting device according to the embodiment.
FIG. 3 is a schematic plan view of a light emitting module.
FIG. 4A is a schematic front view of a wiring pattern on which a control element is mounted, FIG. 4B is a schematic cross-sectional view of the wiring pattern on which the control element is mounted, and FIG. 4C is a schematic enlarged view of A portion in FIG. 4B.
FIG. 5A is a schematic front view of a wiring pattern on which the control element is mounted, FIG. 5B is a schematic cross-sectional view of the wiring pattern on which the control element is mounted, and FIG. 5C is a schematic enlarged view of B portion in FIG. 5B.
FIGS. 6A and 6B are schematic views illustrating other arrangement modes of the wiring patterns, and FIGS. 6C to 6E are cross-sectional views that are taken along line C-C in FIG. 6A or cross-sectional views that are taken along line D-D in FIG. 6B.

### DETAILED DESCRIPTION

According to one embodiment, a light emitting module substrate includes: a base body that is formed using a ceramic; and a wiring pattern which is provided on a surface of the base body and in which a thickness in a region to be soldered is thicker than that in a region other than the region to be soldered.

According to the light emitting module substrate, it is possible to increase a fixing strength between the wiring pattern and the base body, and to improve the reliability.

Furthermore, the wiring pattern may include a first layer and a second layer provided on the first layer; and the second layer may be provided in the region to be soldered.

In this case, it is possible to increase the fixing strength between the wiring pattern and the base body, and to improve the reliability.

Furthermore, the substrate may further include: a metal film that is provided in the region to be soldered and covers the wiring pattern, and has a film formed of nickel and a film formed of gold.

In this case, it is possible to improve the solder wettability or to suppress migration.

According to another embodiment, a light emitting module includes: the light emitting module substrate described above; and a light emitting element that is electrically connected to the wiring pattern provided in the light emitting module substrate.

According to the light emitting module, it is possible to increase the fixing strength between the wiring pattern and the base body, and to improve the reliability.

According to still another embodiment, a lighting device includes: the light emitting module described above; a power feeding terminal that is electrically connected to a wiring pattern provided in the light emitting module; and a socket that is fitted to the power feeding terminal.

According to the lighting device, it is possible to increase the fixing strength between the wiring pattern and the base body, and to improve the reliability.

For example, a light emitting module substrate 2 and a light emitting module 20 according to the embodiment can be, used for a lighting device for a vehicle such as an automobile.

The lighting device for the vehicle may be used if necessary even in an environment of a high temperature and high humidity in which an environment temperature is 85°C and humidity is 85%, for example.

Furthermore, it is necessary for the lighting device for the vehicle to pass a thermal cycle test in which lighting in a high temperature environment (for example, 85°C) and lighting in a low temperature environment (for example, -30°C) are repeated.

Thus, migration described below or peeling of a wiring pattern 24 is likely to occur.

In addition, from demand for miniaturization, the light emitting module substrate 2 used for the lighting device for the vehicle tends to have miniaturization of a base body 21 and short width dimensions of the wiring pattern 24. Thus, fixing strength between the wiring pattern 24 and the base body 21 is likely to be decreased.

Hereinafter, a case where a lighting device 1 according to an embodiment is the lighting device for the vehicle will be described.

However, the light emitting module substrate and the light emitting module according to the embodiment are preferably applied to the vehicle, but, for example, are also capable of being applied to other lighting devices for indoor use and the like.

Hereinafter, the embodiment will be described with reference to the drawings. Moreover, the same reference numerals are given to similar configuration elements in each view and detailed description thereof will be appropriately omitted.

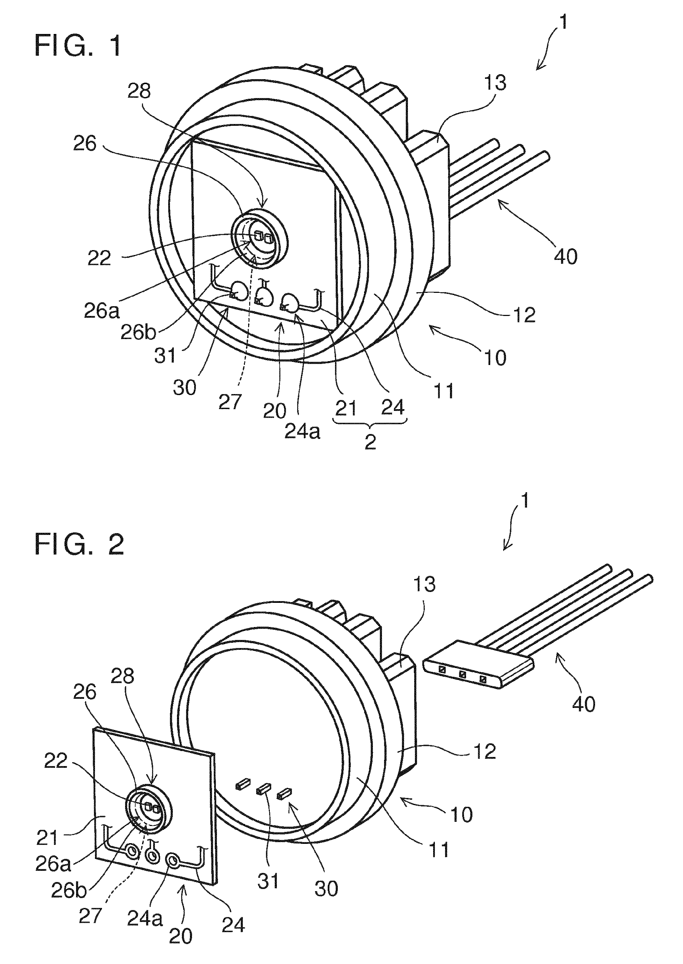

FIGS. 1 and 2 are schematic perspective views illustrating the lighting device 1 according to the embodiment. Furthermore, FIG. 1 is a schematic perspective view of the lighting device 1 and FIG. 2 is a schematic perspective exploded view of the lighting device 1.

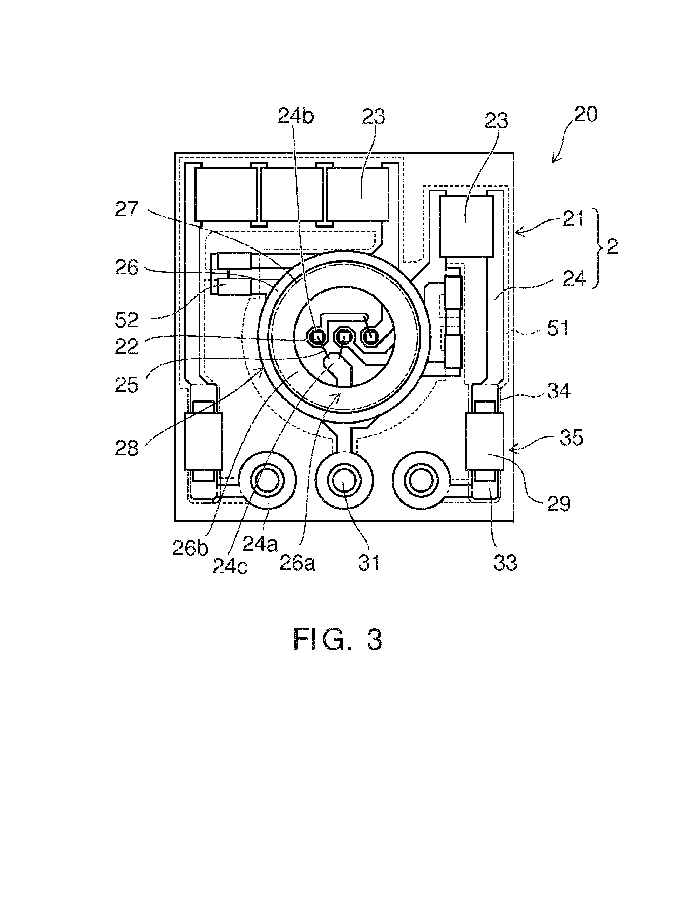

FIG. 3 is a schematic plan view of the light emitting module 20.

As illustrated in FIGS. 1 and 2, the lighting device 1 is provided with a body section 10, the light emitting module 20, a power feeding section 30, and a socket 40.

The body section 10 is provided with a storage section 11, a flange section 12, and a fin 13. The storage section 11 has a cylindrical shape and protrudes from one surface of the flange section 12. The light emitting module 20 is stored inside the storage section 11. Furthermore, a power feeding terminal 31 of the power feeding section 30 protrudes inside the storage section 11.

The flange section 12 has a cylindrical shape and the storage section 11 is provided on one surface and the fin 13 is provided on the other surface.

A plurality of fins 13 protrude from the surface of the flange section 12. The plurality of fins 13 have a plate shape and function as radiating fins.

The body section 10 has functions for storing the light emitting module 20 the power feeding section 30 and the like, and has a function of radiating heat generated in the light emitting module 20 or the power feeding section 30 to the outside of the lighting device 1.

Thus, it is possible to form the body section 10 from a material having a high thermal conductivity considering radiation of the heat to the outside. For example, it is possible to form the body section 10 from aluminum, aluminum alloy, a high thermal conductivity resin, and the like. For example, the high thermal conductivity resin is obtained by mixing fibers or particles of carbon having a high thermal conductivity, aluminum oxide, or the like into resin such as PET, nylon, or the like.

In this case, it is possible to form the fins 13 and the like that are portions in which the heat is radiated from a material having a high thermal conductivity and to form the other portions from resin and the like.

Furthermore, if a main portion of the body section 10 is configured of a conductive material, in order to ensure electrical insulation between the power feeding terminal 31 and the portion of the body section 10 that is formed of the conductive material, an insulation material (not illustrated) covers a periphery of the power feeding terminal 31 and a conductive material may be disposed in the periphery thereof. For example, the insulation material is resin and the like, and a material having a high thermal conductivity is preferably used. Furthermore, the body section 10 may be provided with a mounting section that is used when the lighting device 1 is mounted on a vehicle lighting apparatus.

As illustrated in FIG. 3, the light emitting module 20 is provided with the light emitting module substrate 2, a light emitting element 22, a control element 23, wiring 25, a surrounding wall member 26, a sealing section 27, a joint section 28, a control element 29, a cover section 51, a metal film 34, and a control element 52.

Furthermore, the light emitting module substrate 2 is provided with the base body 21 and the wiring pattern 24.

The base body 21 is provided on the inside of the storage section 11 of the body section 10.

The base body 21 has a plate shape and the wiring pattern 24 is provided in the surface thereof.

The base body 21 is formed from a ceramic such as aluminum oxide or aluminum nitride.

Furthermore, the base body 21 may be a single layer and may be a multi-layer.

The wiring pattern 24 is provided on at least one surface of the base body 21.

The wiring pattern 24 can be provided on both surfaces of the base body 21, but in order to reduce manufacturing costs, the wiring pattern 24 is preferably provided on one surface of the base body 21.

The wiring pattern 24 is provided with an input terminal 24a.

A plurality of input terminals 24a are provided. The power feeding terminal 31 of the power feeding section 30 is electrically connected to the input terminals 24a. Thus, the light emitting element 22 is electrically connected to the power feeding section 30 through the wiring pattern 24.

The wiring pattern 24 is formed from a material having silver as a main component. For example, the wiring pattern 24 is formed from silver or silver alloy.

For example, it is possible to form the wiring pattern 24 by using a screen printing method.

Moreover, a form of the wiring pattern 24 will be described below in detail.

A plurality of light emitting elements 22 are provided on the wiring pattern 24 provided on the surface of the base body 21.

The light emitting element 22 can have an electrode (not illustrated) on a surface (upper surface) opposite to a side provided on the wiring pattern 24. Moreover, the electrode (not illustrated) may be provided on a surface (lower surface) provided on the wiring pattern 24 and on a surface (upper surface) opposite to the side provided on the wiring pattern 24, and may be provided on only one surface thereof.

The electrode (not illustrated) provided on the lower surface of the light emitting element 22 is electrically connected to a mounting pad 24b provided in the wiring pattern 24 through a conductive thermosetting material such as silver paste. The electrode (not illustrated) provided on the upper surface of the light emitting element 22 is electrically connected to a wiring pad 24c provided in the wiring pattern 24 through the wiring 25.

For example, the light emitting element 22 may be a light emitting diode, an organic light emitting diode, a laser diode, and the like.

The upper surface of the light emitting element 22 that is an emitting surface of the light faces the front surface side of the lighting device 1 and, mainly emits the light facing the front surface side of the lighting device 1.

The number, size, arrangement, and the like of the light emitting element 22 are exemplified and are not limited to the embodiment, and may be appropriately changed depending on the size, usage, or the like of the lighting device 1.

The control element 23 is provided on the wiring pattern 24.

The control element 23 controls a current flowing through the light emitting element 22.

Since forward voltage characteristics of the light emitting element 22 have variation, an applied voltage between an anode terminal and a ground terminal is constant, variation occurs in brightness (luminous flux, luminance, luminous intensity, and illuminance) of the light emitting element 22. Thus, the current value flowing through the light emitting element 22 is set to be within a predetermined range by the control element 23 in order for the brightness of the light emitting element 22 to be within a predetermined range.

For example, the control element 23 may be a resistor. For example, the control element 23 may be a surface mount type resistor, a resistor (metal oxide film resistor) having a lead wire, a film-shaped resistor formed by using a screen printing method, and the like.

Moreover, the control element 23 illustrated in FIG. 3 is the film-shaped resistor.

In this case, the current value flowing through the light emitting element 22 may be set to be within a predetermined range by changing a resistance value of the control element 23.

For example, if the control element 23 is the film-shaped resistor, it is possible to change respective resistance values by forming respectively removal sections (not illustrated) by removing a part of the control element 23. In this case, if a part of the control element 23 is removed, respective resistance values increase. Removal of a part of the control element 23 may be performed by applying laser light to the control element 23, for example.

The number, the size, the arrangement, and the like of the control element 23 are not limited to the embodiment and can appropriately be changed depending on the number, specification, or the like of the light emitting elements 22.

The wiring 25 electrically connects an electrode (not illustrated) provided on the upper surface of the light emitting element 22 and the wiring pad 24c provided in the wiring pattern 24.

For example, the wiring 25 may be a wire having gold as a main component. However, the material of the wiring 25 is not limited to gold as the main component and, for example, may be formed of copper as a main component, aluminum as a main component, or the like.

For example, the wiring 25 is electrically connected to the electrode (not illustrated) provided on the upper surface of the light emitting element 22 and the wiring pad 24c provided in the wiring pattern 24 by ultrasonic welding or heat welding. For example, the wiring 25 may be electrically connected to the electrode (not illustrated) provided on the upper surface of the light emitting element 22 and the wiring pad 24c provided in the wiring pattern 24 by using a wire bonding method.

The surrounding wall member 26 is provided on the base body 21 so as to surround the plurality of light emitting elements 22. For example, the surrounding wall member 26 has a circular shape in which the plurality of light emitting elements 22 are disposed in a center portion 26a thereof.

For example, the surrounding wall member 26 may be formed from a resin such as polybutylene terephthalate (PBT) or polycarbonate (PC), or a ceramic.

Furthermore, if the material of the surrounding wall member 26 is a resin, it is possible to improve reflectance with respect to the light emitted from the light emitting element 22 by mixing particles of titanium oxide and the like into the resin.

Moreover, the particles are not limited to the particles of titanium oxide and particles formed from a material having a high reflectance with respect to the light emitted from the light emitting element 22 may be mixed into the resin.

Furthermore, for example, the surrounding wall member 26 may be formed from a white resin.

A side wall surface 26b of the surrounding wall member 26 on the side of the center portion 26a is an inclined surface. Some of the light emitted from the light emitting element 22 is reflected on the side wall surface 26b of the surrounding wall member 26 and is emitted to the front surface side of the lighting device 1.

Furthermore, the light that is some of the light emitted from the light emitting element 22 to the front surface side of the lighting device 1 and is light totally reflected on the upper surface (interface between the sealing section 27 and the outside air) of the sealing section 27 is reflected on the side wall surface 26b of the surrounding wall member 26 on the side of the center portion 26a and is emitted again to the front surface side of the lighting device 1.

That is, the surrounding wall member 26 can have a function of a reflector as well. Moreover, the form of the surrounding wall member 26 is not limited to the embodiment and may be appropriately changed.

The sealing section 27 is provided in the center portion 26a of the surrounding wall member 26. The sealing section 27 is provided so as to cover the inside of the surrounding wall member 26. That is, the sealing section 27 is provided inside the surrounding wall member 26 and covers the light emitting element 22 and the wiring 25.

The sealing section 27 is formed from a material which is a light transmissive material. For example, the sealing section 27 may be formed from silicone resin and the like.

For example, the sealing section 27 may be formed by filling a resin into the center portion 26a of the surrounding wall member 26. Filling of the resin, for example, may be performed by using a liquid fixed quantity dispensing device such as a dispenser.

If the resin is filled into the center portion 26a of the surrounding wall member 26, mechanical contact with respect to the wiring pattern 24, the wiring 25, and the like disposed in the light emitting element 22 and the center portion 26a of the surrounding wall member 26 can be prevented from the outside. Furthermore, moisture, gas, or the like can be prevented from becoming adhered to the wiring pattern 24, the wiring 25, and the like disposed in the light emitting element 22 and the center portion 26a of the surrounding wall member 26. Thus, it is possible to improve the reliability of the lighting device 1.

Furthermore, the sealing section 27 may include a phosphor. For example, the phosphor may be a YAG phosphor (yttrium-aluminum-garnet fluorescence).

For example, if the light emitting element 22 is a blue light emitting diode and the phosphor is the YAG phosphor, the YAG phosphor is excited by the blue light emitted from the light emitting element 22 and yellow fluorescence is emitted from the YAG phosphor. Then, the white light is emitted from the lighting device 1 by mixing the blue light and the yellow light. Moreover, the type of the phosphor or the type of the light emitting element 22 is not limited to the embodiment and may be appropriately changed so as to obtain a desired emission light color depending on the usage of the lighting device 1.

The joint section 28 joins the surrounding wall member 26 and the base body 21.

The joint section 28 has a film shape and is provided between the surrounding wall member 26 and the base body 21.

For example, the joint section 28 may be formed by curing silicone-based adhesive or epoxy-based adhesive.

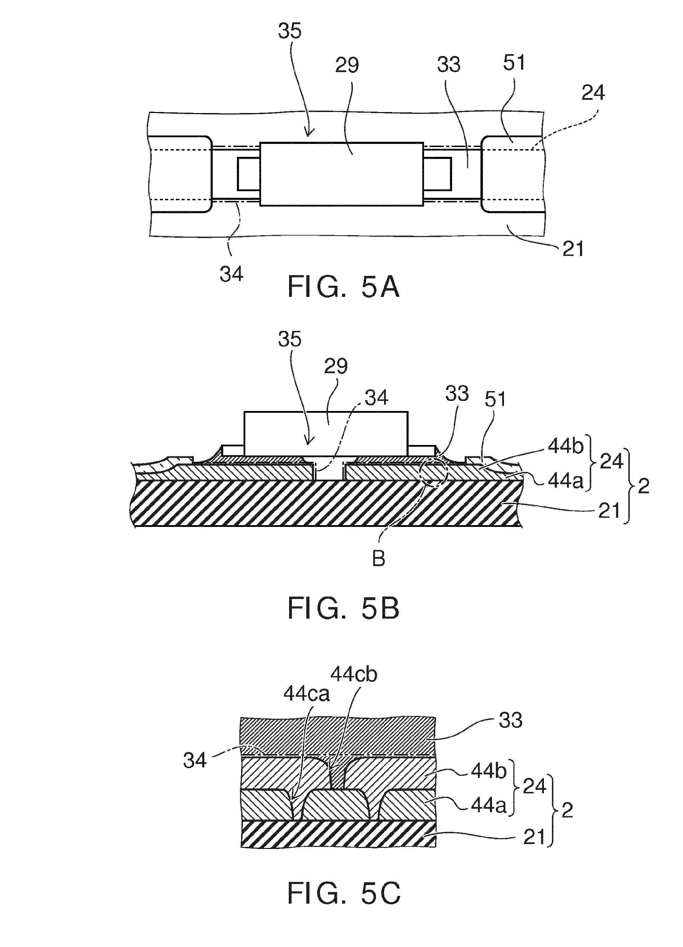

The control element 29 is provided on the wiring pattern 24 through a solder section 33 (see FIGS. 5A and 5B). That is, the control element 29 is soldered on the wiring pattern 24.

The control element 29 is provided such that a reverse voltage is not applied to the light emitting element 22 and pulse noise is not applied to the light emitting element 22 from the opposite direction.

For example, the control element 29 may be a diode. For example, the control element 29 may be a surface mount type diode, a diode having a lead wire, and the like.

The control element 29 illustrated in FIG. 3 is the surface mount type diode.

The control element 52 is provided on the wiring pattern 24.

The control element 52 is provided to detect disconnection of the light emitting diode or to prevent erroneous lighting. The control element 52 is a pull-down resistor.

The control element 52 may be a film-shaped resistor formed by using a screen printing method.

For example, the control element 52 may be a film-shaped resistor formed by using ruthenium oxide.

As illustrated in FIG. 3, the cover section 51 is provided so as to cover a part of the wiring pattern 24, the control element 23 that is the film-shaped resistor, and the control element 52 that is the film-shaped resistor.

Moreover, the cover section 51 is not provided in a portion in which the control element 29 and the light emitting element 22 are provided, a portion to which the wiring 25 is connected, and a portion to which the power feeding terminal 31 is connected.

For example, the cover section 51 does not cover a region 35 to which the control element 29 is soldered.

The cover section 51 is provided so that moisture, gas, or the like is prevented from coming into contact with the wiring pattern 24, the control element 23, and the control element 52, and electrical insulation is ensured. The cover section 51 may include a glass material.

As described above, the wiring pattern 24 is formed from the material having silver as a main component. Thus, migration may occur due to conductivity under high humidity conditions. For example, a short circuit may occur between facing solder sections 33 and the like.

Thus, in order to prevent the migration or to improve the solder wettability, the metal film 34 covering the wiring pattern 24 is provided.

The metal film 34 is provided in the region 35 to be soldered and covers the wiring pattern 24. For example, the metal film 34 may be a laminated film having at least a film formed from nickel and a film formed from gold. For example, the metal film 34 may be formed of a laminated film in which a film formed from nickel and a film formed from gold are laminated in this order, and a laminated film in which a film formed from nickel, a film formed from palladium, and a film formed from gold are laminated in this order.

For example, the metal film 34 is formed in the region 35 to which the soldering is performed by using an electroless plating method.

The power feeding section 30 is provided with the plurality of power feeding terminals 31.

The plurality of power feeding terminals 31 extend to the inside of the storage section 11 and the flange section 12. End portions of the plurality of power feeding terminals 31 protrude from a bottom surface of the storage section 11 and are electrically connected to the input terminal 24a of the wiring pattern 24. The other end portions of the plurality of power feeding terminals 31 are exposed from a side opposite to a side on which the base body 21 of the body section 10 is provided.

Moreover, the number, arrangement, a form, and the like of the power feeding terminals 31 are not limited to the embodiment and may be appropriately changed.

Furthermore, the power feeding section 30 may include a substrate (not illustrated) or a circuit part such as a capacitor or a resistor. Moreover, for example, the substrate (not illustrated) or the circuit part may be provided inside the storage section 11 or the flange section 12.

The socket 40 is fitted into end portions of the plurality of power feeding terminals 31 exposed from the body section 10.

A power supply (not illustrated) and the like are electrically connected to the socket 40.

Thus, the power supply (not illustrated) and the like, and the light emitting element 22 are electrically connected to each other by fitting the socket 40 into the end portion of the power feeding terminal 31.

For example, the socket 40 may be joined to an element on the side of the body section 10 by using adhesive and the like.

Next, a form of a wiring pattern 124 is further illustrated.

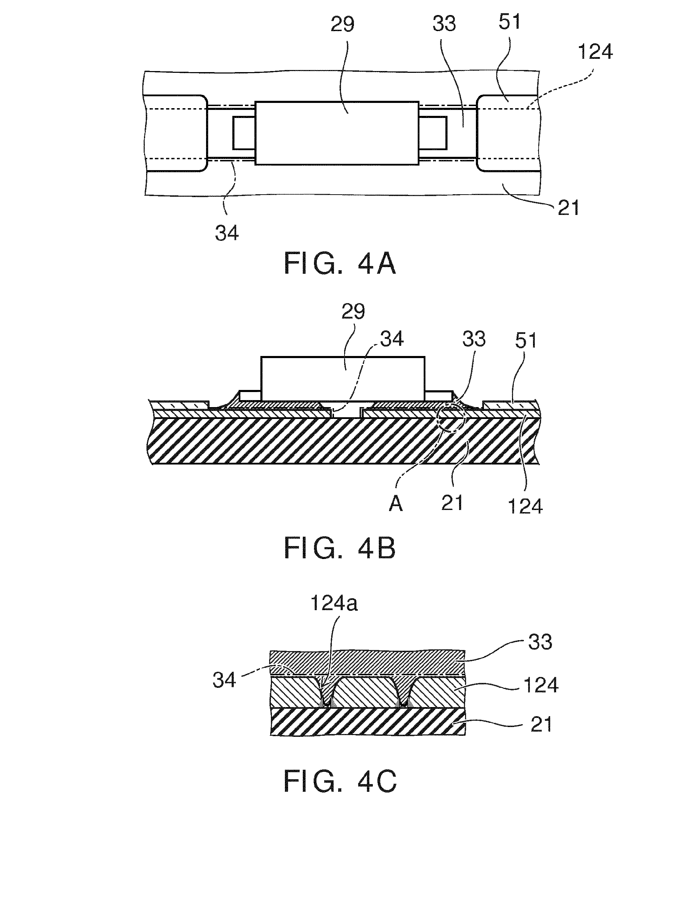

FIGS. 4A to 4C are schematic views illustrating the form of the wiring pattern 124 according to a comparison example.

FIG. 4A is a schematic front view of the wiring pattern 124 on which the control element 29 is mounted.

FIG. 4B is a schematic cross-sectional view of the wiring pattern 124 on which the control element 29 is mounted.

FIG. 4C is a schematic enlarged view of A portion in FIG. 4B.

As illustrated in FIGS. 4A and 4B, the wiring pattern 124 is provided in the surface of the base body 21.

The wiring pattern 124 is formed from a material having silver as a main component. The wiring pattern 124 is formed by using a screen printing method.

The control element 29 is provided on the wiring pattern 124 through the solder section 33. That is, the control element 29 is soldered onto the wiring pattern 124.

The cover section 51 is provided so as to cover the wiring pattern 124. In this case, the cover section 51 does not cover the region 35 in which the control element 29 is soldered.

Here, the part such as the control element 29 that is soldered preferably has a high fixing strength to the light emitting module substrate 2. Thus, it is preferable that the solder section 33 be unlikely to be damaged and the wiring pattern 124 be unlikely to be peeled from the base body 21.

However, when forming the wiring pattern 124 using the screen printing method or the like, as illustrated in FIG. 4C, a pinhole 124a reaching an interface between the wiring pattern 124 and the base body 21 may be formed. As described above, when forming the pinhole 124a, peeling of the wiring pattern 124 is likely to occur with reference to the pinhole 124a.

Furthermore, as described above, the metal film 34 is formed by using the electroless plating method. When forming the metal film 34 by using the electroless plating method, acidic chemical solution may enter the inside of the pinhole 124a. When the acidic chemical solution enters the inside of the pinhole 124a, there is a concern that the pinhole 124a may become larger and a fixing strength between the wiring pattern 124 and the base body 21 may decrease.

FIGS. 5A to 5C are schematic views illustrating a form of the wiring pattern 24 of the embodiment.

FIG. 5A is a schematic front view of the wiring pattern 24 on which the control element 29 is mounted.

FIG. 5B is a schematic cross-sectional view of the wiring pattern 24 on which the control element 29 is mounted.

FIG. 5C is a schematic enlarged view of portion B in FIG. 5B.

As illustrated in FIGS. 5A and 5B, the wiring pattern 24 is provided on the surface of the base body 21.

Moreover, a thickness of the wiring pattern 24 in the region 35 to be soldered is thicker than that of the wiring pattern 24 in a region other than the region 35 to be soldered.

As illustrated in FIG. 5C, in the region 35 to be soldered, a wiring pattern 44b (corresponding to an example of a second layer) is further formed on a wiring pattern 44a (corresponding to an example of a first layer), and thereby the thickness of the wiring pattern 24 may be thickened in the region 35 to be soldered.

That is, the wiring pattern 24 has the wiring pattern 44a and the wiring pattern 44b provided on the wiring pattern 44a. Thus, the wiring pattern 44b is provided in the region 35 to be soldered.

Here, when forming the wiring pattern 44a on the substrate 21 by using the screen printing method, a pinhole 44ca passing through the wiring pattern 44a may be formed.

When forming the wiring pattern 44b on the wiring pattern 44a using a screen printing method, a pinhole 44cb passing through the wiring pattern 44b may be formed.

However, the pinhole 44ca and the pinhole 44cb are randomly formed. Thus, the pinhole 44ca and the pinhole 44cb rarely overlap.

Thus, it is possible to prevent the pinhole from being formed which reaches the interface between the wiring pattern 44a and the base body 21 from the surface of the wiring pattern 44b.

Furthermore, the wiring pattern 44b is embedded inside the pinhole 44ca. Furthermore, the wiring pattern 44a and the wiring pattern 44b are integrally formed by firing the wiring pattern 44a and the wiring pattern 44b.

In this case, the pinhole 44cb is left, but the pinhole does not reach the interface between the wiring pattern 44a (the wiring pattern 24) and the base body 21.

Thus, peeling of the wiring pattern 24 is unlikely to occur with reference to the pinhole.

Furthermore, when forming the metal film 34, the chemical solution does not reach the interface between the wiring pattern 44a (the wiring pattern 24) and the base body 21 even if the acidic chemical solution enters the inside of the pinhole 44cb. Thus, it is possible to prevent the fixing strength between the wiring pattern 24 and the base body 21 from decreasing.

Moreover, as an example, a case where the control element 29 is soldered is exemplified, but the same applies to a case where other members are soldered.

The other members are, for example, the light emitting diode, the resistor, the diode, a Zener diode, a capacitor, and the like.

FIGS. 5A to 5C illustrate a case where the wiring pattern 44a and the wiring pattern 44b are overlapped, but the case is not limited to the embodiment.

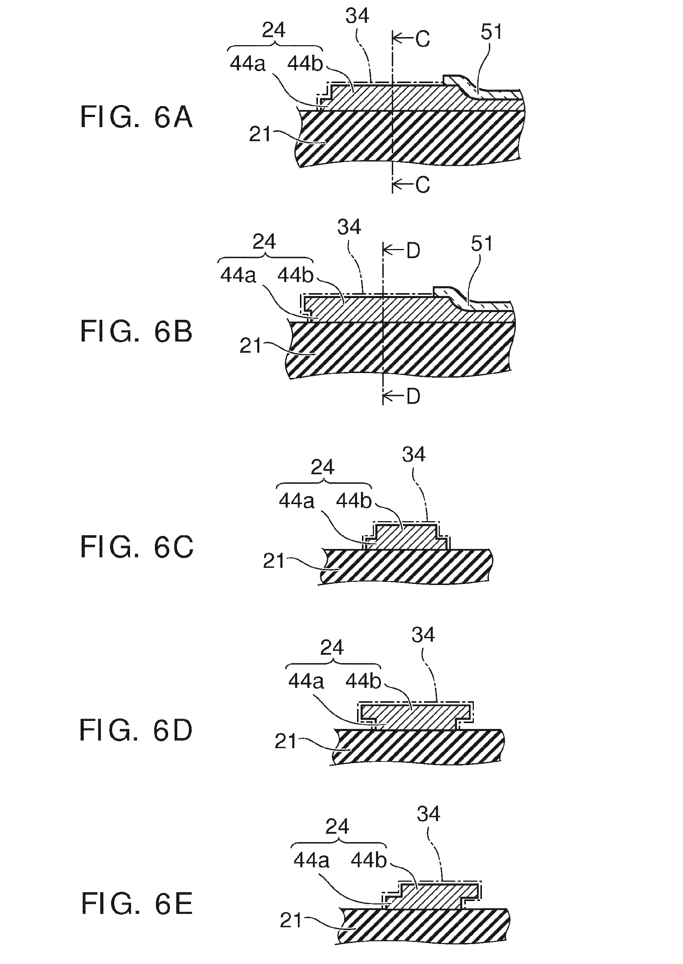

FIGS. 6A to 6E are schematic views illustrating other arrangement forms of the wiring pattern 44a and the wiring pattern 44b.

Moreover, FIGS. 6C to 6E are cross-sectional views that are taken along line C-C in FIG. 6A or cross-sectional views that are taken along line D-D in FIG. 6B.

If the wiring pattern 44b is screen printed on the wiring pattern 44a, as illustrated in FIGS. 6A to 6E, it is possible to apply a material so that an end portion of the wiring pattern 44b is positioned on the outside or inside from an end portion of the wiring pattern 44a.

Here, as illustrated in FIGS. 6B, 6D, and 6E, when performing the screen printing, whereby the end portion of the wiring pattern 44b is positioned on the outside from the end portion of the wiring pattern 44a, since the wiring pattern 44b has a paste shape, the wiring pattern 44b is configured to be hung on a side of the base body 21 by gravity after performing screen printing. As a result, finally, as illustrated in FIG. 6A or 6C, the end portion of the wiring pattern 44b is configured to be positioned on the inside of the end portion of the wiring pattern 44a.

As described above, it is possible to increase a contact area between the wiring patterns 44a and 44b, and the metal film 34. Furthermore, it is possible to produce an anchoring effect with respect to the metal film 34.

Thus, the metal film 34 is unlikely to peel off.

Moreover, above is a case where two layers of the wiring pattern 24 (the wiring patterns 44a and 44b) are provided in the region 35 to be soldered, but the number of the laminated layers is not limited to two layers. The number of the laminated layers may be more than one and, for example, may be three layers or more.

Next, manufacturing of the lighting device 1 is illustrated. First, the light emitting module substrate 2 is formed.

The wiring pattern 24 having a predetermined form is formed on the surface of the base body 21 using the ceramic.

For example, the wiring pattern 44a having a predetermined form is formed by applying a paste-type material on the surface of the base body 21 by using a screen printing method.

For example, the paste-shaped material may include silver or silver alloy powder and organic solvent.

For example, the organic solvent may be toluene, xylene, and the like.

Subsequently, the wiring pattern 44a is dried.

Subsequently, the wiring pattern 44b is formed by applying the paste-shaped material on the wiring pattern 44a in the region 35 to be soldered by using a screen printing method.

Subsequently, the wiring pattern 44b is dried.

Subsequently, the wiring pattern 24 is formed by firing the wiring pattern 44a and the wiring pattern 44b.

As described above, it is possible to form the light emitting module substrate 2.

Next, the control element 23 and the control element 52 are formed.

For example, the paste-shaped material is applied to the surface of the base body 21 by using the screen printing method. For example, the paste-shaped material may include ruthenium oxide powder and organic solvent.

For example, the organic solvent may be toluene, xylene, and the like.

Subsequently, the applied paste-shaped material is dried and the control element 23 and the control element 52 having predetermined forms are formed by firing the paste-shaped material.

Moreover, the formation of the control element 23 and the control element 52 may be formed when forming the light emitting module substrate 2.

Subsequently, a resistance value of the control element 23 is adjusted by using a laser trimming method and the like. Next, the cover section 51 is formed.

First, glass paste is made.

For example, the glass paste may include glass powder, filler, and organic solvent.

For example, the glass powder may include silicon, barium, calcium, bismuth, and the like.

For example, the filler may include aluminum oxide.

For example, the organic solvent may be toluene, xylene, and the like.

Subsequently, the glass paste is applied to a predetermined region of the surface of the base body 21 by using a screen printing method.

Subsequently, the cover section 51 is formed by firing the glass paste.

Next, the metal film 34 is formed by using an electroless plating method.

Next, the light emitting element 22, the control element 29, and the like are mounted, and the surrounding wall member 26 is bonded.

For example, the light emitting element 22 is bonded on the wiring pattern 24 by using a die mounting method. Furthermore, a portion between the electrode of the light emitting element 22 and the wiring pattern 24 is connected by the wiring 25 by using a wire bonding method.

The control element 29 is soldered on the wiring pattern 24.

Subsequently, the resin is filled in the center portion 26a of the surrounding wall member 26 and the sealing section 27 is formed.

For example, the filling of the resin may be performed by using a liquid fixed quantity dispensing device such as a dispenser.

The resin may include a desired phosphor.

As described above, it is possible to manufacture the light emitting module 20.

Next, the light emitting module 20 is mounted on the body section 10 and the wiring pattern 24 provided in the light emitting module 20 and the power feeding terminal 31 are electrically connected to each other.

As described above, it is possible to manufacture the lighting device 1.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions. Moreover, the above-mentioned embodiments can be combined mutually and can be carried out.

## Claims

1. A light emitting module substrate (2) comprising:
a base body (21) that is formed using a ceramic; and
a wiring pattern (24) which is provided on a surface of the base body (21) and in which a thickness in a region (35) to be soldered is thicker than that in a region other than the region to be soldered.

2. The substrate (2) according to claim 1,
wherein the wiring pattern (24) includes a first layer (44a) and a second layer (44b) provided on the first layer (44a); and
wherein the second layer (44b) is provided in the region (35) to be soldered.

3. The substrate (2) according to claim 1 or 2, further comprising:
a metal film (34) that is provided in the region (35) to be soldered and covers the wiring pattern (24), and includes a film formed of nickel and a film formed of gold.

4. A light emitting module (20) comprising:
the light emitting module substrate (2) according to any one of claims 1 to 3; and
a light emitting element (22) that is electrically connected to a wiring pattern (24) provided on the light emitting module substrate (2).

5. A lighting device (1) comprising:
the light emitting module (20) according to claim 4;
a power feeding terminal (31) that is electrically connected to a wiring pattern (24) provided in the light emitting module (20); and
a socket (40) that is fitted to the power feeding terminal (31).
